# EUROPEAN PATENT APPLICATION

(11) **EP 4 300 733 A1**
(43) Date of publication of application: **03.01.2024**
(21) Application number: 21927423.0
(22) Date of filing: 27.05.2021
(51) Int. Cl.: H02B 1/20, H02B 1/24, H02J 9/04

(54) **NEW-TYPE BUS POWER DISTRIBUTION MICROMODULE**

(30) Priority: 25.02.2021 CN 202110214975
(71) Applicant: Vertiv Tech (Xi'An) Co., Ltd., Xi'an, Shaanxi 710005 (CN)
(72) Inventor: GAO, Cheng, Shaanxi 710005 (CN); FENG, Xiaobo, Shaanxi 710005 (CN); LI, Xing, Shaanxi 710005 (CN); LIU, Xin, Shaanxi 710005 (CN); WANG, Tengjiang, Shaanxi 710005 (CN)
(74) Representative: Morrall, Jonathan Ian McLachlan
(86) International application number: PCT/CN2021/096248
(87) International publication number: WO 2022/178990

(57) **Abstract**

A bus power distribution micromodule, comprising a UPS; a channel door, which contains a bus starting end A; and at least one cabinet, which contains a bus section A1 or A2, wherein an input end of the bus starting end A is connected to the UPS, an output end thereof is connected to the bus section A1 or A2 by means of a connector (600), and the bus section A1 or A2 is disposed in the cabinet and connected to a power distribution apparatus of the cabinet. In the bus power distribution micromodule, by means of using the connector to rapidly connect the bus starting end to the bus section and each bus section, a plug-and-play property, easy expansion and IT load flexible matching of the cabinet are realized; the bus starting end is integrated in the channel door of the micromodule, thereby facilitating convenient maintenance and operation; an inter-column power distribution cabinet is not required for the whole bus power distribution micromodule, so that the beneficial effect of same having a small occupied area is achieved; and, moreover, bus links can be in communication after the cabinets are combined, so that the bus power distribution micromodule has the advantage of rapid delivery.

## Description

This application claims the priority to Chinese Patent Application No. 202110214975.4, titled "NEW-TYPE BUS POWER DISTRIBUTION MICROMODULE", filed with the China National Intellectual Property Administration on February 25, 2021, the entire disclosure of which is incorporated herein by reference.

### FIELD

The present disclosure relates to the technical field of power distribution, in particular to a new-type bus power distribution micromodule.

### BACKGROUND

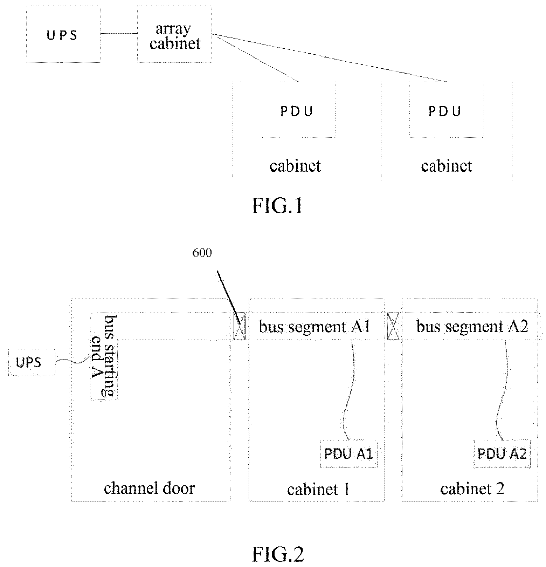

A power distribution system of a conventional data center adopts a fixed power distribution cabinet to realize the power distribution of IT equipment. As shown in FIG. 1, generally, a fixed number and a fixed capacity of branches of array cabinets are used to distribute power to a power distribution unit (PDU) of each cabinet. Therefore, the power of a single cabinet needs to be confirmed in advance. When the capacity of a certain cabinet changes, it cannot be flexibly adapted. In addition, since the switch and wiring of the branches are fixed, it is difficult to change them in the later stage and the scalability is poor. Moreover, on-site processing of cables and wiring is required, resulting in a large workload, poor construction consistency, slow delivery, and an additional floor space for a separate distribution cabinet is required.

### SUMMARY

The technical problem to be solved by the present disclosure is to provide a new-type bus power distribution micromodule, which can realize plug-and-play property, easy expansion, and IT load flexible matching of a power distribution system, and has the advantages of convenient maintenance and operation, small occupied area and rapid delivery.

The technical solution adopted by the present disclosure to solve the technical problem is to provide a new-type bus power distribution micromodule, which includes a UPS, a channel door which includes a bus starting end and at least one cabinet which includes a bus segment, wherein an input end of the bus starting end is connected with the UPS, an output end of the bus starting end is connected with the bus segment through a connector, and the bus segment is arranged in the cabinet and is connected with a power distribution device of the cabinet.

The new-type bus power distribution micromodule according to the present disclosure includes multiple bus segments, wherein each bus segment is arranged in the cabinet and is connected with the power distribution device of the cabinet, a first bus segment of the multiple bus segments is connected with the output end of the bus starting end through the connector, and the multiple bus segments are connected with each other through connectors.

In the new-type bus power distribution micromodule according to the present disclosure, the UPS includes a first UPS, the bus starting end includes a first bus starting end, the multiple bus segments include a first group of bus segments and a second group of bus segments, an input end of the first bus starting end is connected with the first UPS, a first output end of the first bus starting end is connected with the first group of bus segments through a connector, a second output end of the first bus starting end is connected with the second group of bus segments through a connector, each of the first group of bus segments is arranged in a first group of cabinets in one-to-one correspondence, and each of the second group of bus segments is arranged in a second group of cabinets in one-to-one correspondence.

In the new-type bus power distribution micromodule according to the present disclosure, the UPS includes a first UPS, the bus starting end includes a first bus starting end, the multiple bus segments include a first group of bus segments and a second group of bus segments, an input end of the first bus starting end is connected with the first UPS, a first output end of the first bus starting end is connected with the first group of bus segments through a connector, a second output end of the first bus starting end is connected with the second group of bus segments through a connector,
at least one bus segment of the first group of bus segments is integrated on the first UPS, and the remaining bus segments of the first group of bus segments are arranged in a first group of cabinets in one-to-one correspondence respectively;
at least one bus segment of the second group of bus segments is integrated on an air conditioner and supplies power to the air conditioner, the remaining bus segments of the second group of bus segments are arranged in a second group of cabinets in one-to-one correspondence respectively, or, at least one bus segment of the second group of bus segments is integrated on an air conditioner, the remaining bus segments of the second group of bus segments are arranged in a second group of cabinets in one-to-one correspondence respectively, and an air conditioning power distribution module that supplies power to the air conditioner is provided in the channel door.

In the new-type bus power distribution micromodule according to the present disclosure, the UPS includes a first UPS, the bus starting end includes a first bus starting end and a second bus starting end, the multiple bus segments include a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the first bus starting end through a connecting assembly, a first output end of the second bus starting end is connected with the third group of bus segments through a connector, a second output end of the second bus starting end is connected with the fourth group of bus segments through a connector, each of the first group of bus segments and the third group of bus segments is arranged in a first group of cabinets in one-to-one correspondence, and each of the second group of bus segments and the fourth group of bus segments is arranged in a second group of cabinets in one-to-one correspondence.

In the new-type bus power distribution micromodule according to the present disclosure, the UPS includes a first UPS, the bus starting end includes a first bus starting end and a second bus starting end, the bus segments include a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the first bus starting end through a connecting assembly, a first output end of the second bus starting end is connected with the third group of bus segments through a connector, and a second output end of the second bus starting end is connected with the fourth group of bus segments through a connector; at least one bus segment of the first group of bus segments and the third group of bus segments is integrated on the first UPS, and the remaining bus segments of the first group of bus segments and the third group of bus segments are arranged in a first group of cabinets in one-to-one correspondence respectively;
at least one bus segment of the second group of bus segments and the fourth group of bus segments is integrated on an air conditioner and supplies power to the air conditioner, the remaining bus segments of the second group of bus segments and the fourth group of bus segments are arranged in a second group of cabinets in one-to-one correspondence respectively; or, at least one bus segment of the second group of bus segments and the fourth group of bus segments is integrated on an air conditioner, the remaining bus segments of the second group of bus segments and the fourth group of bus segments are arranged in a second group of cabinets in one-to-one correspondence respectively, and an air conditioning power distribution module that supplies power to the air conditioner is provided in the channel door. In the new-type bus power distribution micromodule according to the present disclosure, the UPS includes a first UPS and a second UPS, the bus starting end includes a first bus starting end and a second bus starting end, the multiple bus segments include a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the second UPS, a first output end of the second bus starting end is connected with the third group of bus segments through a connector, and a second output end of the second bus starting end is connected with the fourth group of bus segments through a connector, each of the first group of bus segments and the third group of bus segments is arranged in a first group of cabinets in one-to-one correspondence, and each of the second group of bus segments and the fourth group of bus segments is arranged in a second group of cabinets in one-to-one correspondence.

In the new-type bus power distribution micromodule according to the present disclosure, the UPS includes a first UPS and a second UPS, the bus starting end includes a first bus starting end and a second bus starting end, the multiple bus segments include a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the second UPS, a first output end of the second bus starting end is connected with the third group of bus segments through a connector, and a second output end of the second bus starting end is connected with the fourth group of bus segments through a connector,
at least one bus segment of the second group of bus segments and the fourth group of bus segments is integrated on an air conditioner and supplies power to the air conditioner, the remaining bus segments of the second group of bus segments and the fourth group of bus segments are arranged in a second group of cabinets in one-to-one correspondence respectively; or, at least one bus segment of the second group of bus segments and the fourth group of bus segments is integrated on an air conditioner, the remaining bus segments of the second group of bus segments and the fourth group of bus segments are arranged in a second group of cabinets in one-to-one correspondence respectively, and an air conditioning distribution module that supplies power to the air conditioner is provided in the channel door.

In the new-type bus power distribution micromodule according to the present disclosure, the bus starting end includes a power distribution switch device, a power supply indication device, a power measuring and metering device, a lightning protection device and a power environment monitoring device, and the bus segment includes a power distribution switch device.

In the new-type bus power distribution micromodule according to the present disclosure, each cabinet includes a monitoring unit which is arranged between the bus segment and the power distribution device for the management of power distribution and power measuring and metering of the power distribution device of the cabinet; the new-type bus power distribution micromodule further includes a temperature detection device for detecting an operating temperature of the connector.

By implementing the new-type bus power distribution micromodule according to the present disclosure, the plug-and-play property, easy expansion, the IT load flexible matching of the cabinets are realized by rapidly connecting the bus starting end with the bus segment and each bus segment through the connectors. The bus starting end is integrated in the channel door of the micromodule, thereby facilitating convenient maintenance and operation. An inter-column power distribution cabinet is not required for the whole bus power distribution micromodule, so that the beneficial effect of having a small occupied area is realized. Moreover, bus links can be in communication after the cabinets are combined, so that the new-type bus power distribution micromodule has the advantages of rapid delivery. Further, the bus starting end has 2N structure, and the bus segment in the cabinet also has 2N structure, which can avoid single point of failure. Furthermore, online detection and maintenance can be realized by the monitoring unit and the temperature detection device, thereby improving the availability of the power distribution circuit. In addition, the functions of power detection, power distribution management and switch protection of the power distribution device of the cabinet are realized by providing the monitoring unit.

### BRIEF DESCRIPTION OF THE DRAWINGS

The present disclosure is further described hereinafter in conjunction with the accompanying drawings. In the drawings:
FIG. 1 is a schematic block diagram of a power distribution system in the conventional technology;
FIG. 2 is a schematic block diagram of a new-type bus power distribution micromodule according to a first preferred embodiment of the present disclosure;
FIG. 3 is a schematic block diagram of the new-type bus power distribution micromodule according to a second preferred embodiment of the present disclosure;
FIG. 4 is a schematic block diagram of the new-type bus power distribution micromodule according to a third preferred embodiment of the present disclosure;
FIG. 5 is a schematic block diagram of the new-type bus power distribution micromodule according to a fourth preferred embodiment of the present disclosure;
FIG. 6 is a circuit schematic diagram of the new-type bus power distribution micromodule according to a fifth preferred embodiment of the present disclosure;
FIG. 7 is a circuit schematic diagram of the new-type bus power distribution micromodule according to a sixth preferred embodiment of the present disclosure;
FIG. 8 is a schematic structural diagram of the new-type bus power distribution micromodule shown in FIG. 2;
FIG. 9 is a schematic block diagram of the new-type bus power distribution micromodule according to a seventh preferred embodiment of the present disclosure; and
FIG. 10 is a schematic block diagram of the new-type bus power distribution micromodule according to an eighth preferred embodiment of the present disclosure.

### DETAILED DESCRIPTION OF EMBODIMENTS

In order to illustrate the objectives, technical solutions and advantages of the present disclosure more clearly, the present disclosure will be further described in detail below in conjunction with the drawings and embodiments. It should be understood that the specific embodiments described herein are only for the purpose of explaining the present disclosure, but not to limit the present disclosure.

The present disclosure relates to a new-type bus power distribution micromodule which includes a UPS, a channel door which includes a bus starting end and at least one cabinet which includes a bus segment. An input end of the bus starting end is connected with the UPS, an output end of the bus starting end is connected with the bus segment through a connector, and the bus segment is arranged in the cabinet and is connected with a power distribution device of the cabinet. By implementing the new-type bus power distribution micromodule according to the present disclosure, a plug-and-play property, easy expansion and IT load flexible matching of the cabinets are realized by rapidly connecting the bus starting end with the bus segment and each bus segments through connectors. The bus starting end is integrated in the channel door of the micromodule, thereby facilitating convenient maintenance and operation. An inter-column power distribution cabinet is not required for the whole bus power distribution micromodule, so that the beneficial effect of having a small occupied area is realized. Moreover, bus links can be in communication after the cabinets are combined, so that the new-type bus power distribution micromodule has the advantages of rapid delivery.

FIG. 2 is a schematic block diagram of a new-type bus power distribution micromodule according to a first preferred embodiment of the present disclosure. As shown in FIG. 2, the new-type bus power distribution micromodule includes a UPS, a bus starting end A, and bus segments A1 and A2. As shown in FIG. 2, an input end of the bus starting end A is connected with the UPS, and an output end of the bus starting end A is connected with the bus segment A1 through a connector 600. Similarly, the bus segment A1 is connected with the bus segment A2 through a connector 600. The bus starting end A is arranged in a channel door 500. The bus segments A1 and 320 are arranged in cabinets 1 and 2 respectively and are connected with power distribution devices PDU A1 and PDU A2 of the cabinets 1 and 2 respectively.

In a further preferred embodiment of the present disclosure, multiple bus segments can be included and each bus segment is arranged in the cabinet and is connected with the power distribution device of the cabinet. A first bus segment of the multiple bus segments, such as the bus segment A1 shown in FIG. 2, is connected with the output end of the bus starting end A through the connector 600, and each of the multiple bus segments is connected with each other through connectors 600. In a simplified embodiment of the present disclosure, only the bus segment A1 can be included.

The above embodiment adopts a power distribution mode in which one UPS is used in cooperation with a single bus starting end and the bus segment, which is suitable for the operation mode in which the operational requirement for IT equipment is not high.

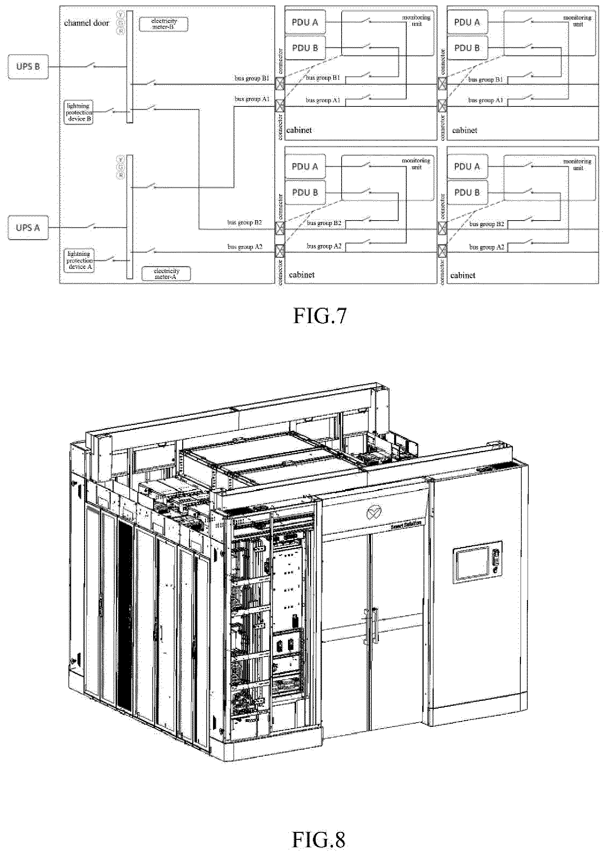

FIG. 8 is a schematic structural diagram of the new-type bus power distribution micromodule shown in FIG. 2. As shown in FIG. 8, the bus segment A1 is integrated on a top surface of the cabinet A1. Similarly, the bus segment A2 is integrated on a top surface of the cabinet A2. In this way, after the cabinet 1 and the cabinet 2 are combined, each of the bus segments is connected in sequence to form a complete bus circuit. At this time, the power distribution devices PDU A1 and PDU A2 of each of the cabinets take power from the bus segment of the current cabinet to supply power to the IT equipment. Therefore, when an additional cabinet needs to be added, rapid expansion can be realized by simply combining and connecting a cabinet. Each cabinet only needs to determine the maximum power and takes power from the bus circuit in a flexible manner according to an actual operating power after delivery. The same is true when a larger number of the bus segments are included. Further, since the bus starting end A, the bus segment A1 and the bus segment A2 are rapidly connected through the connectors 600, on-site wiring engineering is completely eliminated and the rapid delivery is realized. Since the design is standardized, the engineering factors of cable processing, such as inconsistent wiring routing, poor crimping quality of cable terminals, and insufficient fixing torque of cable terminals, are avoided. In this way, the bus starting end A integrated in the channel door is rapidly connected with the bus segment integrated on the top surface of the cabinet through connectors, so that plug-and-play property, flexibility, scalability, engineering-free, rapid delivery, high availability, and easy maintenance performance of the new-type bus power distribution micromodule are realized. Since the bus starting end A is not hung on the top surface of the cabinet and is integrated in the channel door, the operator can perform maintenance operation conveniently without climbing up.

Preferably, the bus starting end A includes a power distribution switch device, a power supply indication device, a power measuring and metering device, a lightning protection device and a power environment monitoring device, which can realize the functions of total power distribution and metering and protection of the new-type bus power distribution micromodule. The bus segment includes a power distribution switch device.

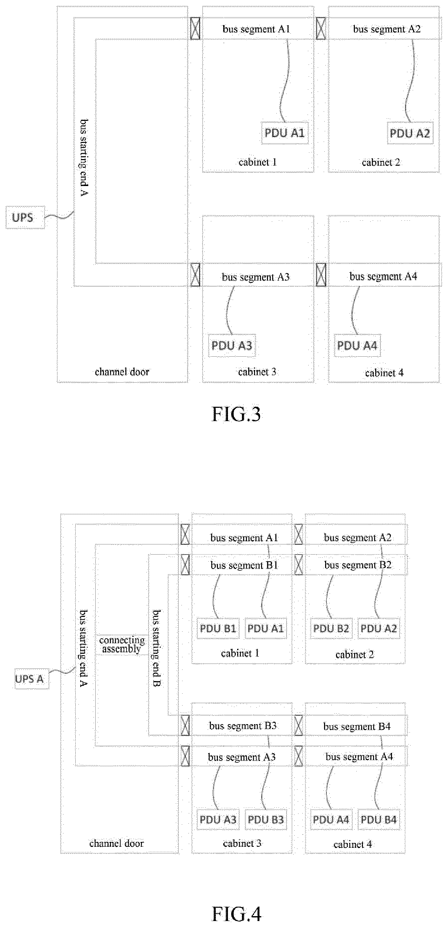

FIG. 3 is a schematic block diagram of the new-type bus power distribution micromodule according to a second preferred embodiment of the present disclosure. In the embodiment shown in FIG. 3, one bus starting end cooperates with one UPS and two groups of bus segments. In this embodiment, an input end of the bus starting end A is connected with the UPS, a first output end of the bus starting end A is connected with the first group of bus segments through a connector; a second output end of the bus starting end A is connected with the second group of bus segments through a connector. The first group of bus segments includes bus segments A1 and A2, and the second group of bus segments includes bus segments A3 and A4. The bus segment A1 is connected with the bus starting end A and the bus segment A2 through connectors respectively. Similarly, the bus segment A3 is connected with the bus starting end A and the bus segment A4 through connectors respectively. Each of the bus segments A1 and A2 is arranged in cabinets 1 and 2 in one-to-one correspondence, each of the bus segments A3 and A4 is arranged in cabinets 3 and 4 in one-to-one correspondence, and each bus segment corresponds to one power distribution device PDU.

FIG. 4 is a schematic block diagram of the new-type bus power distribution micromodule according to a third preferred embodiment of the present disclosure. In the embodiment shown in FIG. 4, one UPS, two bus starting ends, and four groups of bus segments, that is, a UPS A, bus starting ends A and B, bus segments A1 and A2, bus segments B1 and B2, bus segments A3 and A4, and bus segments B3 and B4 are included. An input end of the bus starting end A is connected with the UPS A, a first output end of the bus starting end A is connected with the bus segments A1 and A2 in sequence through a connector, a second output end of the bus starting end A is connected with the bus segments A3 and A4 in sequence through a connector, an input end of the bus starting end B is connected with the bus starting end A through a connecting assembly (such as a copper bar), a first output end of the bus starting end B is connected with the bus segments B1 and B2 through a connector, and a second output end of the bus starting end B is connected with the bus segments B3 and B4 through a connector. The bus segments A1 and B1 are arranged in a cabinet 1, the bus segments A2 and B2 are arranged in a cabinet 2, the bus segments A3 and B3 are arranged in a cabinet 3, the bus segments A4 and B4 are arranged in a cabinet 4, and each bus segment corresponds to one bus power distribution device PDU, that is, the bus segments A1 to A4 correspond to PDU A1 to PDU A4 respectively, and the bus segments B 1 to B4 correspond to PDU B 1 to PDU B4 respectively.

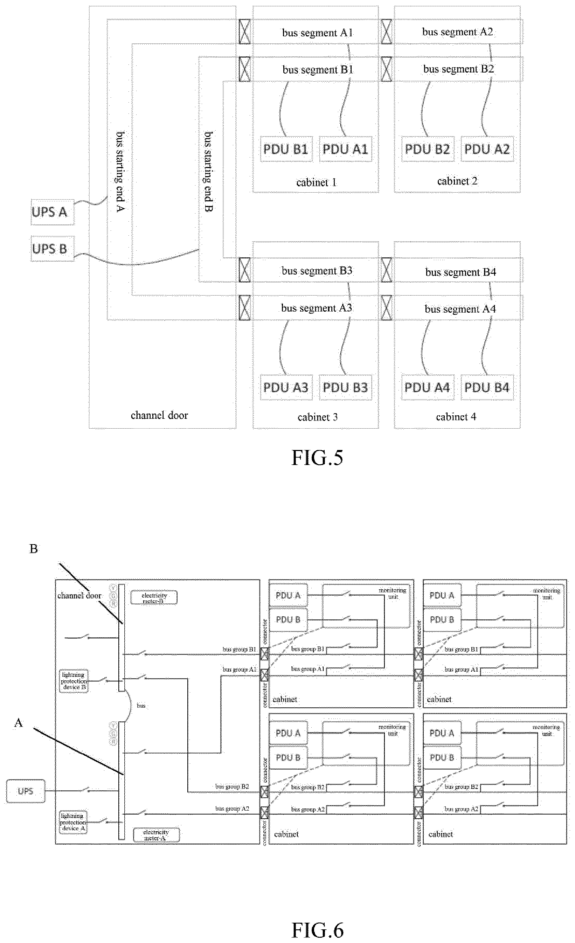

FIG. 5 is a schematic block diagram of the new-type bus power distribution micromodule according to a fourth preferred embodiment of the present disclosure. In the embodiment shown in FIG. 5, two UPSs, two bus starting ends, four groups of bus segments, that is, a UPS A and a UPS B, bus starting ends A and B, bus segments A1 and A2, bus segments B1 and B2, bus segments A3 and A4, and bus segments B3 and B4 are included. An input end of the bus starting end A is connected with the UPS A, a first output end of the bus starting end A is connected with the bus segments A1 and A2 in sequence through a connector, a second output end of the bus starting end A is connected with the bus segments A3 and A4 in sequence through a connector, an input end of the bus starting end B is connected with the UPS B, a first output end of the bus starting end B is connected with the bus segments B1 and B2 through a connector, and a second output end of the bus starting end B is connected with the bus segments B3 and B4 through a connector. The bus segments A1 and B 1 are arranged in a cabinet 1, the bus segments A2 and B2 are arranged in a cabinet 2, the bus segments A3 and B3 are arranged in a cabinet 3, and the bus segments A4 and B4 are arranged in a cabinet 4. Each bus segment corresponds to one power distribution device PDU, that is, the bus segments A1 to A4 correspond to PDU A1 to PDU A4 respectively, and the bus segments B 1 to B4 correspond to PDU B 1 to PDU B4 respectively.

FIG. 6 is a circuit schematic diagram of the new-type bus power distribution micromodule according to a fifth preferred embodiment of the present disclosure. One UPS cooperates with dual bus starting ends and bus segments, and is also suitable for scenes where the operational requirement for IT equipment is not high. As shown in FIG. 6, the new-type bus power distribution micromodule includes a UPS, bus starting ends A and B, bus groups A1, B 1, A2 and B2. Each bus group includes multiple bus segments, wherein the bus starting end A, the bus groups A1 and A2 form one circuit, and the bus starting end B, the bus groups B1 and B2 form another circuit. An input end of the bus starting end A is connected with the UPS, and an output end of the bus starting end A is connected with the bus groups A1 and A2 through a connector. A first bus segment of the bus groups A1 and A2 is connected with the bus starting end A through a connector, and the remaining bus segments of the bus groups A1 and A2 are connected with each other through connectors. An input end of the bus starting end B is connected with the UPS, and an output end of the bus starting end B is connected with the bus groups B 1 and B2 through a connector. A first bus segment of the bus groups B 1 and B2 is connected with the bus starting end B through a connector, and the remaining bus segments of the bus groups B1 and B2 are connected with each other through connectors. Similarly, each circuit may include a greater or lesser number of bus segments, which is not repeated herein. Each bus starting end includes a power distribution switch device, a power supply indication device, a power measuring and metering device, a lightning protection device and a power environment monitoring device, and each bus segment includes s a power distribution switch device.

FIG. 7 is a circuit schematic diagram of the new-type bus power distribution micromodule according to a sixth preferred embodiment of the present disclosure. In order to ensure the long-term stable operation of the IT equipment, the bus starting end uses 2N structure, and the bus segment in the cabinet also uses 2N structure, which can avoid single point of failure.

As shown in FIG. 7, the new-type bus power distribution micromodule according to the present disclosure includes a first UPS A and a second UPS B, a first bus starting end and a second bus starting end, and bus groups A1, B1, A2 and B2, and each bus group includes multiple bus segments. Similarly, the first bus starting end, the bus groups A1 and A2 form one circuit, and the second bus starting end, the bus groups B1 and B2 form another circuit. An input end of the bus starting end A is connected with the UPS, and an output end of the bus starting end A is connected with the bus groups A1 and A2 through a connector. A first bus segment of the bus groups A1 and A2 is connected with the bus starting end A through a connector, and the remaining bus segments of the bus groups A1 and A2 are connected with each other through connectors. An input end of the bus starting end B is connected with the UPS, and an output end of the bus starting end B is connected with the bus groups B 1 and B2 through a connector. In the embodiment shown in FIG. 7, the bus starting end includes a power distribution switch device, an indicator light YGA, an electricity meter A, a lightning protection device A and a monitoring device. Each bus segment of the bus groups A1, B1, A2 and B2 is arranged in cabinets respectively to supply power to power distribution devices PDUA and PDUB in the cabinets respectively. A monitoring unit is provided in each cabinet, so as to realize the functions of power detection, power distribution management and switch protection of the power distribution device in this cabinet. In other preferred embodiments of the present disclosure, an intelligent power distribution device may be used to realize the functions of power detection, power distribution management and switch protection. In this embodiment, two starting end assemblies are mounted in the channel door, and bus segments are mounted on two rows of cabinets. After cabinets are combined during mounting, the bus connectors are connected, the connector integrated in the channel door is connected with the connector in the adjacent first cabinet, thus forming a complete bus power distribution circuit.

The new-type bus power distribution micromodule according to the present disclosure further includes a temperature detection device for detecting an operating temperature of the connector 600, so as to detect the operating temperature in real time, give an abnormal high temperature alarm, meet the requirements of safe operation, and facilitate the fault diagnosis.

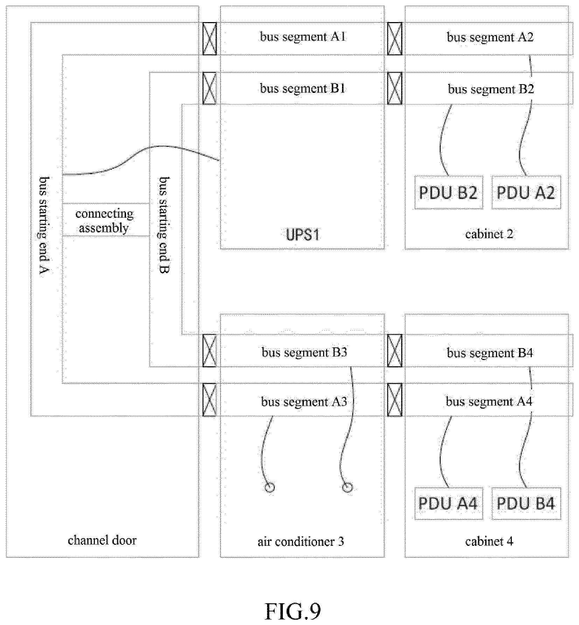

FIG. 9 is a schematic block diagram of the new-type bus power distribution micromodule according to a seventh preferred embodiment of the present disclosure. As shown in FIG. 9, the new-type bus power distribution micromodule in this embodiment includes one UPS, two bus starting ends, four groups of bus segments, that is a UPS 1, bus starting ends A and B, bus segments A1 and A2, bus segments B1 and B2, bus segments A3 and A4, and bus segments B3 and B4. An input end of the bus starting end A is connected with the UPS 1, a first output end of the bus starting end A is connected with the bus segments A1 and A2 in sequence through a connector, a second output end of the bus starting end A is connected with the bus segments A3 and A4 in sequence through a connector, an input end of the bus starting end B is connected with the bus starting end A through a connecting assembly, a first output end of the bus starting end B is connected with the bus segments B1 and B2 through a connector, and a second output end of the bus starting end B is connected with the bus segments B3 and B4 through a connector. The bus segments A1 and B1 are integrated on the UPS 1, the bus segments A2 and B2 are arranged in a cabinet 2, the bus segments A3 and B3 are integrated on an air conditioner 3 and directly supply power to the air conditioner 3, the bus segments A4 and B4 are arranged in a cabinet 4, each bus segment in the cabinet corresponds to one power distribution device PDU, that is, the bus segments A2 and B2 correspond to PDU A2 and PDU B2 respectively, and the bus segments A4 and B4 correspond to PDU A4 and PDU B4 respectively. In this embodiment, the bus starting end in the channel door is connected to the UPS, and a complete bus link in a column-entering scene is formed by integrating the bus segments on the UPS and the air conditioner. At the same time, the bus integrated on the air conditioner directly supplies power to the air conditioner without providing an air conditioner power distribution module, thus realizing the continuous cooling mode of the UPS-powered air conditioner.

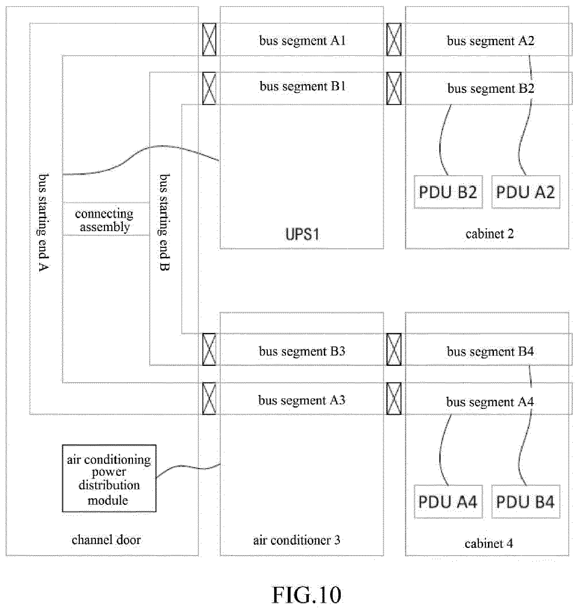

FIG. 10 is a schematic block diagram of the new-type bus power distribution micromodule according to an eighth preferred embodiment of the present disclosure. As shown in FIG. 10, the new-type bus power distribution micromodule in this embodiment includes one UPS, two bus starting ends, four groups of bus segments, that is, a UPS 1, bus starting ends A and B, bus segments A1 and A2, bus segments B1 and B2, bus segments A3 and A4, and bus segments B3 and B4. An input end of the bus starting end A is connected with the UPS 1, a first output end of the bus starting end A is connected with the bus segments A1 and A2 in sequence through a connector, a second output end of the bus starting end A is connected with the bus segments A3 and A4 in sequence through a connector, an input end of the bus starting end B is connected with the bus starting end A through a connecting assembly, a first output end of the bus starting end B is connected with the bus segments B1 and B2 through a connector, and a second output end of the bus starting end B is connected with the bus segments B3 and B4 through a connector. The bus segments A1 and B1 are integrated on the UPS1, the bus segments A2 and B2 are arranged in a cabinet 2, the bus segments A3 and B3 are integrated on an air conditioner 3, the bus segments A4 and B4 are arranged in a cabinet 4, each bus segment in the cabinet corresponds to one power distribution device PDU, that is, the bus segments A2 and B2 correspond to PDU A2 and PDU B2 respectively, and the bus segments A4 and B4 correspond to PDU A4 and PDU B4 respectively. In this embodiment, an air conditioner power distribution module is provided in the channel door to supply power to the air conditioner 3. In this embodiment, the bus starting end in the channel door is connected to the UPS, a complete bus link in a column-entering scene is formed by integrating the bus segments on the UPS and the air conditioner. At the same time, the air conditioner power distribution module is integrated in channel door to supply power to the air conditioner, without the need for a separate air conditioning power distribution cabinet, thus saving the occupied area.

In a further preferred embodiment of the present application, those skilled in the art are aware that in any embodiments shown in FIG. 3 to 6, the cabinet 1 can be replaced with a UPS, and the cabinet 2 can be replaced with an air conditioner. Of course, the cabinet 2 can be replaced with a UPS, and cabinet 1 can also be replaced with an air conditioner. The specific control method can refer to the embodiments shown in FIG. 9 and FIG. 10, and is not repeated herein.

By implementing the new-type bus power distribution micromodule according to the present disclosure, the plug-and-play property, easy expansion, the IT load flexible matching are realized by rapidly connecting UPS with the bus starting end, the bus starting end with the bus segment and each bus segment through the connectors while the beneficial effects of convenient maintenance and operation and having a small occupied area can also be achieved. Further, the bus starting end uses 2N structure, and the bus segment in the cabinet also uses 2N structure, which can avoid single point of failure. Furthermore, online detection and maintenance can be realized by the monitoring unit and the temperature detection device, thereby improving the availability of the distribution circuit. In addition, the bus starting end is integrated in channel door, thus facilitating maintenance operation, and the functions of power detection, power distribution management and switch protection of the power distribution device of the cabinet are realized by providing the monitoring unit.

Although the present disclosure has been disclosed above through the description of specific embodiments of the disclosure, it should be understood that multiple modifications and equivalent substitutions can be applied to the present disclosure without departing from the scope of the present disclosure. In addition, various modifications may be made to the present disclosure for specific situations or materials without departing from the scope of the present disclosure. Therefore, the present disclosure is not limited to the specific embodiments disclosed, and should include all embodiments falling within the scope of the claims of the present disclosure.

The above is only a preferred embodiment of the present disclosure, and is not intended to limit the present disclosure. Any modifications, equivalent substitutions, improvements made within the spirit and principles of the present disclosure should be included in the scope of protection of the present disclosure.

## Claims

1. A new-type bus power distribution micromodule, **characterized by** comprising a UPS, a channel door comprising a bus starting end and at least one cabinet comprising a bus segment, wherein an input end of the bus starting end is connected with the UPS, an output end of the bus starting end is connected with the bus segment through a connector, and the bus segment is arranged in the cabinet and is connected with a power distribution device of the cabinet.

2. The new-type bus power distribution micromodule according to claim 1, **characterized by** comprising a plurality of bus segments, wherein each bus segment is arranged in the cabinet and is connected with the power distribution device of the cabinet, a first bus segment of the plurality of bus segments is connected with the output end of the bus starting end through a connector, and the plurality of bus segments are connected with each other through a connector.

3. The new-type bus power distribution micromodule according to claim 2, **characterized in that** the UPS comprises a first UPS, the bus starting end comprises a first bus starting end, the plurality of bus segments comprise a first group of bus segments and a second group of bus segments, an input end of the first bus starting end is connected with the first UPS, a first output end of the first bus starting end is connected with the first group of bus segments through a connector, a second output end of the first bus starting end is connected with the second group of bus segments through a connector, each of the first group of bus segments is arranged in a first group of cabinets in one-to-one correspondence, and each of the second group of bus segments is arranged in a second group of cabinets in one-to-one correspondence.

4. The new-type bus power distribution micromodule according to claim 1, **characterized in that** the UPS comprises a first UPS, the bus starting end comprises a first bus starting end, the plurality of bus segments comprise a first group of bus segments and a second group of bus segments, an input end of the first bus starting end is connected with the first UPS, a first output end of the first bus starting end is connected with the first group of bus segments through a connector, a second output end of the first bus starting end is connected with the second group of bus segments through a connector;
at least one bus segment of the first group of bus segments is integrated on the first UPS, and the remaining bus segments of the first group of bus segments are arranged in a first group of cabinets in one-to-one correspondence respectively;
at least one bus segment of the second group of bus segments is integrated on an air conditioner and supplies power to the air conditioner, the remaining bus segments of the second group of bus segments are arranged in a second group of cabinets in one-to-one correspondence respectively, or, at least one bus segment of the second group of bus segments is integrated on an air conditioner, the remaining bus segments of the second group of bus segments are arranged in a second group of cabinets in one-to-one correspondence respectively, and an air conditioning power distribution module that supplies power to the air conditioner is provided in the channel door.

5. The new-type bus power distribution micromodule according to claim 2, **characterized in that** the UPS comprises a first UPS, the bus starting end comprises a first bus starting end and a second bus starting end, the plurality of bus segments comprise a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the first bus starting end through a connecting assembly, a first output end of the second bus starting end is connected with the third group of bus segments through a connector, a second output end of the second bus starting end is connected with the fourth group of bus segments through a connector, each of the first group of bus segments and the third group of bus segments are arranged in a first group of cabinets in one-to-one correspondence, and each of the second group of bus segments and the fourth group of bus segments are arranged in a second group of cabinets in one-to-one correspondence.

6. The new-type bus power distribution micromodule according to claim 1, **characterized in that** the UPS comprises a first UPS, the bus starting end comprises a first bus starting end and a second bus starting end, the plurality of bus segments comprise a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the first bus starting end through a connecting assembly, a first output end of the second bus starting end is connected with the third group of bus segments through a connector, and a second output end of the second bus starting end is connected with the fourth group of bus segments through a connector; at least one bus segment of the first group of bus segments and the third group of bus segments is integrated on the first UPS, and the remaining bus segments of the first group of bus segments and the third group of bus segments are arranged in a first group of cabinets in one-to-one correspondence respectively;
at least one bus segment of the second group of bus segments and the fourth group of bus segments is integrated on an air conditioner and supplies power to the air conditioner, and the remaining bus segments of the second group of bus segments and the fourth group of bus segments are arranged in a second group of cabinets in one-to-one correspondence respectively; or, at least one bus segment of the second group of bus segments and the fourth group of bus segments is integrated on an air conditioner, the remaining bus segments of the second group of bus segments and the fourth group of bus segments are arranged in a second group of cabinets in one-to-one correspondence respectively, and an air conditioning power distribution module that supplies power to the air conditioner is provided in the channel door.

7. The new-type bus power distribution micromodule according to claim 2, **characterized in that** the UPS comprises a first UPS and a second UPS, the bus starting end comprises a first bus starting end and a second bus starting end, the plurality of bus segments comprise a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the second UPS, a first output end of the second bus starting end is connected with the third group of bus segments through a connector, a second output end of the second bus starting end is connected with the fourth group of bus segments through a connector, each of the first group of bus segments and the third group of bus segments is arranged in a first group of cabinets in one-to-one correspondence, and each of the second group of bus segments and the fourth group of bus segments are arranged in a second group of cabinets in one-to-one correspondence.

8. The new-type bus power distribution micromodule according to claim 1, **characterized in that** the UPS comprises a first UPS and a second UPS, the bus starting end comprises a first bus starting end and a second bus starting end, the plurality of bus segments comprise a first group of bus segments, a second group of bus segments, a third group of bus segments and a fourth group of bus segments, an input end of the first bus starting end is connected with the first UPS, a first output end of the first bus starting end is connected with the first group of bus segments through a connector, a second output end of the first bus starting end is connected with the second group of bus segments through a connector, an input end of the second bus starting end is connected with the second UPS, a first output end of the second bus starting end is connected with the third group of bus segments through a connector, and a second output end of the second bus starting end is connected with the fourth group of bus segments through a connector,
at least one bus segment of the second group of bus segments and the fourth group of bus segments is integrated on an air conditioner and supplies power to the air conditioner, and the remaining bus segments of the second group of bus segments and the fourth group of bus segments are arranged in a second group of cabinets in one-to-one correspondence respectively; or, at least one bus segment of the second group of bus segments and the fourth group of bus segments is integrated on an air conditioner, the remaining bus segments of the second group of bus segments and the fourth group of bus segments are arranged in a second group of cabinets in one-to-one correspondence respectively, and an air conditioning power distribution module that supplies power to the air conditioner is provided in the channel door.

9. The new-type bus power distribution micromodule according to any one of claims 1 to 8, **characterized in that** the bus starting end comprises a power distribution switch device, a power supply indication device, a power measuring and metering device, a lightning protection device and a power environment monitoring device, and the bus segment comprises a power distribution switch device.

10. The new-type bus power distribution micromodule according to claim 9, **characterized in that** each cabinet comprises a monitoring unit which is arranged between the bus segment and the power distribution device for the management of power distribution and power measuring and metering of the power distribution device of the cabinet; the new-type bus power distribution micromodule further comprises a temperature detection device for detecting an operating temperature of the connector.
